# EUROPEAN PATENT APPLICATION

(11) **EP 4 426 083 A1**
(43) Date of publication of application: **04.09.2024**
(21) Application number: 22886936.8
(22) Date of filing: 24.10.2022
(51) Int. Cl.: H10B 63/10, H10B 63/00, H10N 70/00, H10N 99/00

(54) **AMORPHOUS MATERIAL AND CROSS-POINT TYPE MEMORY**

(30) Priority: 27.10.2021 JP 2021175169
(71) Applicant: National Institute of Advanced Industrial Science and Technology, Chiyoda-ku Tokyo 100-8921 (JP)
(72) Inventor: HATAYAMA, Shogo, Tsukuba-shi, Ibaraki 305-8560 (JP); SAITO, Yuta, Tsukuba-shi, Ibaraki 305-8560 (JP); UCHIDA, Noriyuki, Tsukuba-shi, Ibaraki 305-8560 (JP)
(74) Representative: V.O.
(86) International application number: PCT/JP2022/039485
(87) International publication number: WO 2023/074609

(57) **Abstract**

A material according to the present invention is an amorphous material that contains Hf, O and Te as main components and has characteristics of an electrical resistance transitioning from a first state to a second state that is lower than the first state at a specific threshold voltage. A pair of a selector portion containing such an amorphous material and a memory portion is sandwiched between two electrode wirings, whereby a cross-point type memory is obtained.

## Description

### [Technical Field]

The present invention relates to an amorphous material that can be used for, for example, selectors in cross-point type memories and a cross-point type memory.

### [Background Art]

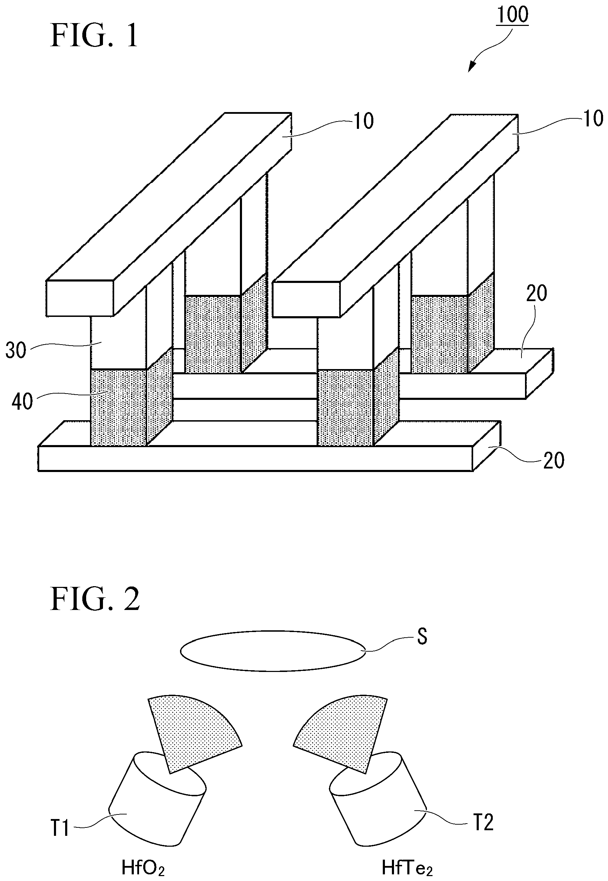

Cross-point type memories have a structure capable of realizing a high degree of integration and have already been employed as commercially available non-volatile memories. This structure has a form in which pairs of a selector portion and a memory portion are sandwiched between the top and bottom electrode wirings as shown in FIG. 1. The memory portion exhibits non-volatile resistance changes and is formed of, for example, a material composed of Ge-Sb-Te. On the other hand, the selector portion has a role of designating memory portions that perform writing and reading and has been formed of a As-Se-Ge-Si-based amorphous material in the related art. This is to realize ovonic threshold switching (OTS) with the non-linear I-V characteristics of amorphous chalcogenide materials. However, As-Se-Ge-Si-based OTS materials are toxic and contain As and Se which cause a high environmental load.

In addition, Patent Document 1 proposes a tertiary or quaternary OTS material containing at least one element of As, Se and Pb as a material for selectors. All of As, Se and Pb cause a high environmental load and are toxic repellent elements, which is a problem.

Furthermore, Patent Document 2 discloses that a tellurium-containing compound layer as a selector contains at least one M1 element selected from Sn, Cu and Bi, Te and O. However, the M1 element does not include Hf, and the details of an electrical resistance change thereof are unclear.

In addition, Patent Document 3 describes that at least one chalcogen element selected from Te, Se and S is contained as a material for selectors, but the environmental load is high in a case where Se is used.

Furthermore, in Non-Patent Document 1, the fact that an X-Zn-Te (X: Be, Mg or Ca)-based material composed of Zn and Te has substantially no higher threshold voltage Vₜₕ than practical OTS materials is theoretically shown by the first-principles calculation, which is merely a study showing only prediction by the first-principles calculation, and no actual electrical resistance changes are described.

In addition, Non-Patent Document 2 shows the OTS characteristics of a Si-Ge-As-Te-based amorphous material composed of Si, Ge, As and Te, but As is contained, and the environmental load is high.

Non-Patent Document 3 shows HfTesOs, which is a Hf-Te-O-based compound, as a crystal material not as an amorphous material, but whether or not the material has characteristics enabling the material to be used as selectors in cross-point type memories is not disclosed.

### [Citation List]

### [Patent Document]

[Patent Document 1]
   Japanese Unexamined Patent Application, First Publication No. 2018-198321
[Patent Document 2]
   Japanese Unexamined Patent Application, First Publication No. 2021-48258
[Patent Document 3]
   Japanese Patent No. 6613142

### [Non-Patent Document]

[Non-Patent Document 1]
   Yun-Jae Lee, Minwoo Han, Su-Hyun Yoo, and Aloysius Soon, "Tunable Threshold Voltage of ZnTe-Based Ovonic Switching Devices via Isovalent Cation Exchange", ACS Applied Electronic Materials 3, 1107-1114 (2021).
[Non-Patent Document 2]
   D. Garbin, W. Devulder, R. Degraeve, G. L. Donadio, S. Clima, K. Opsomer, A. Fantini, D. Cellier, W. G. Kim, M. Pakala, A. Cockbum, C. Detavernier, R. Delhougne, L. Goux, G. S. Kar, "Composition Optimization and Device Understanding of Si-Ge-As-Te Ovonic Threshold Switch Selector with Excellent Endurance", Proceedings of 2019 Int. Electron Devices Meeting (IEDM) 35.1.1-35.1.4
[Non-Patent Document 3]
   J. Galy, G. Meunier, "Sur de nouveaux composes de formule MTesOs (M= Ti, Zr, Hf, Sn) de structure fluorine deformee", Comptes Rendus des Seances de l'Academic des Sciences, Serie C: Sciences Chimiques 268 1249-1252 (1969).

### [Summary of Invention]

### [Technical Problem]

Therefore, according to one aspect, an object of the present invention is to provide a new material causing a low environmental load and having characteristics enabling the material to be used for selectors in cross-point type memories.

### [Solution to Problem]

A material according to a first aspect of the present invention is an amorphous material that contains Hf, O and Te as main components and has characteristics of an electrical resistance transitioning from a first state to a second state that is lower than the first state at a specific threshold voltage in a case where the applied voltage is increased.

In addition, in the material according to the aspect, the electrical resistance transitions from the second state to the first state at a specific voltage in a case where the applied voltage is unloaded.

In addition, a material according to a second aspect of the present invention is an amorphous material that contains Hf, O and Te as main components and is for a selector in a cross-point type memory.

In addition, the amorphous material according to the aspect is represented by a general formula HfₓTe_{y}O_{100-x-y} ··· (1), and in the formula (1), x and y may be 23.0 < x < 32.0, 10.0 < y < 22.0 and 35 ≤ x + y ≤ 50.

In addition, in the formula (1), x and y may be 23.0 < x < 30.0 and 13.0 < y < 22.0.

In addition, in the formula (1), x and y may be 23.0 < x < 28.0 and 15.0 < y < 22.0.

A cross-point type memory according to one aspect of the present invention has a first electrode wiring, a second electrode wiring, a memory portion and a selector portion containing the amorphous material according to the above-described aspect, and the memory portion and the selector portion are disposed between the first electrode wiring and the second electrode wiring.

### [Advantageous Effects of Invention]

According to one aspect, a material causing a low environmental load and having characteristics enabling the material to be used for selectors in cross-point type memories can be obtained.

### [Brief Description of Drawings]

FIG. 1 is a view showing a structural example of a cross-point type memory.
FIG. 2 is a view schematically showing a film formation step of a Hf-Te-O film.
FIG. 3 is a view showing measurement results of an example and comparative examples by an X-ray diffraction method.
FIG. 4 is a cross-sectional view of an element for evaluating threshold switch characteristics.
FIG. 5 is a view showing the I-V characteristics of Comparative Example 1.
FIG. 6 is a view showing the I-V characteristics of Example 1.
FIG. 7 is a view showing the I-V characteristics of a case where the band gap Eg is 1.0 eV in a numerical simulation and Example 1.
FIG. 8 is a view showing the I-V characteristics in the numerical simulation.
FIG. 9 is a view indicating a relationship between the band gap Eg and the threshold voltage Vₜₕ in the numerical simulation.

### [Description of Embodiments]

A material according to an embodiment of the present invention is an amorphous material containing Hf, O and Te and having threshold switch characteristics of the electrical resistance transitioning from a high state to a low state at a specific threshold voltage Vₜₕ in a case where the applied voltage is increased.

Such an amorphous material is used as a selector in a cross-point type memory and exhibits an abrupt resistance change from an off state where the electrical resistance is high to an on state where the electrical resistance is low when a voltage of the threshold voltage Vₜₕ or higher is applied thereto. More specifically, in a case where the applied voltage is lower than the threshold voltage Vₜₕ, the selector portion transitions to the off state, whereby a current toward the memory portion is cut off, and when the voltage applied to the selector portion becomes equal to or higher than the threshold voltage Vₜₕ, the selector portion transitions to the on state, and a current is let to flow toward the memory portion through the selector portion. Such threshold switch characteristics of the selector portion are those of reversible and abrupt occurrence.

The amorphous material according to the present embodiment changes from the on state where the electrical resistance is low to the off state where the electrical resistance is high or vice versa between amorphous and amorphous. The ratio of the electrical resistance in the off state where the electrical resistance is high to the electrical resistance in the on state where the electrical resistance is low is, for example, 10 times or more.

The present inventors non-obviously found that the amorphous material containing Hf, O and Te preferably has a band gap Eg in a range of 1.0 eV ≤ Eg ≤ 1.5 eV in order to be used for selectors in cross-point type memories.

Such a Eg range can be represented as described below as the range of the composition of the amorphous material containing Hf, O and Te. That is, there is a relationship represented by a general formula HfₓTe_{y}O_{100-x-y} . . . (1) among Hf, O and Te, and in the formula (1), x (at.%) and y (at.%) are selected in ranges of 23.0 < x < 32.0 and 10.0 < y < 22.0 so that 35 (at.%) ≤ x + y ≤ 50 (at.%) is satisfied.

Furthermore, the threshold voltage Vₜₕ as the threshold switch characteristics is preferably in a range of 0.8 V ≤ Vₜₕ ≤ 2.0 V Such a condition corresponds to the fact that, in the formula (1), x is in a range of 23.0 < x < 30.0 and y is in a range of 13.0 < y < 22.0.

Furthermore, the threshold voltage Vₜₕ as the threshold switch characteristics is more preferably in a range of 0.8 V ≤ Vₜₕ ≤ 1.5 V Such a condition corresponds to the fact that, in the formula (1), x is in a range of 23.0 < x < 28.0 and y is in a range of 15.0 < y < 22.0.

A cross-point type memory 100 is formed such that a plurality of pairs of a selector portion 30 and a memory portion 40 are sandwiched between the top and bottom electrode wirings, that is, between an electrode 10 and an electrode 20, as shown in FIG. 1. The selector portion 30 is formed of the amorphous material described above. The selector portion 30 is formed by, for example, forming films of HfO₂ (Eg = 5.6 eV), which is an insulator and has a large band gap Eg, and HfTe₂ (Eg = 0 eV), which is a semimetal, by sputtering at the same time. That is, in order to form the selector portion 30, there is a need to perform sputtering using, for example, a first alloy target T1 composed of HfO₂ and a second alloy target T2 composed of HfTe₂ and form films thereof on a substrate S composed of Si or glass. As described above, the composition of Hf, Te and O is adjusted to be within a composition range where the amorphous material has the threshold switch characteristics by controlling the target output in the sputtering of two materials having extremely different band gaps Eg.

### [Examples]

Hereinafter, the present invention will be described in more detail by showing examples, but the present invention is not limited to these examples by any means.

### <Film formation>

FIG. 2 is a view for describing a film formation step of a Hf-Te-O film. As schematically shown in FIG. 2, Hf-Te-O films were formed on a SiO₂/Si substrate and a sapphire substrate by the RF magnetron sputtering method at room temperature. Here, a plurality of thin film specimens having different compositions were produced using a HfOz alloy target and a HfTe₂ alloy target by controlling the output ratio for each and regarded as Example 1 and Comparative Example 1 to Comparative Example 4. Here, as described above, for each of Example 1 and Comparative Example 1 to Comparative Example 4, there are a specimen having a Hf-Te-O film formed on a SiO₂/Si substrate and a specimen having a Hf-Te-O film formed on a sapphire substrate for convenience. However, the Hf-Te-O films formed in each of the example and the comparative examples are considered to have the same characteristics regardless of the type of the substrate.

The compositions of the specimens of Example 1 and Comparative Example 1 to Comparative Example 4 produced on the SiO₂/Si substrates in an off state were measured by the Rutherford backscattering spectrometry. The Rutherford backscattering spectrometry was performed under the following conditions.

Incident ion: ⁴He⁺⁺, incident energy: 2300 keV, incident angle: 0°, scattering angle: 160°, specimen current: 18 nA, beam diameter: 2 mmφ, in-plane rotation: none, irradiation quantity: 150 µC

The compositions obtained regarding Example 1 and Comparative Example 1 to Comparative Example 4 are as shown in Table 1 below.

**[Table 1]**

| | Hf (at.%) | Te (at.%) | O (at.%) | Eg (eV) |
|---|---|---|---|---|
| Example 1 | 24 | 21 | 55 | 1.0 |
| Comparative Example 1 | 34 | 0 | 66 | 5.0 |
| Comparative Example 2 | 32 | 10 | 58 | 1.5 |
| Comparative Example 3 | 16 | 29 | 55 | 0.52 |
| Comparative Example 4 | 14 | 44 | 42 | 0.46 |

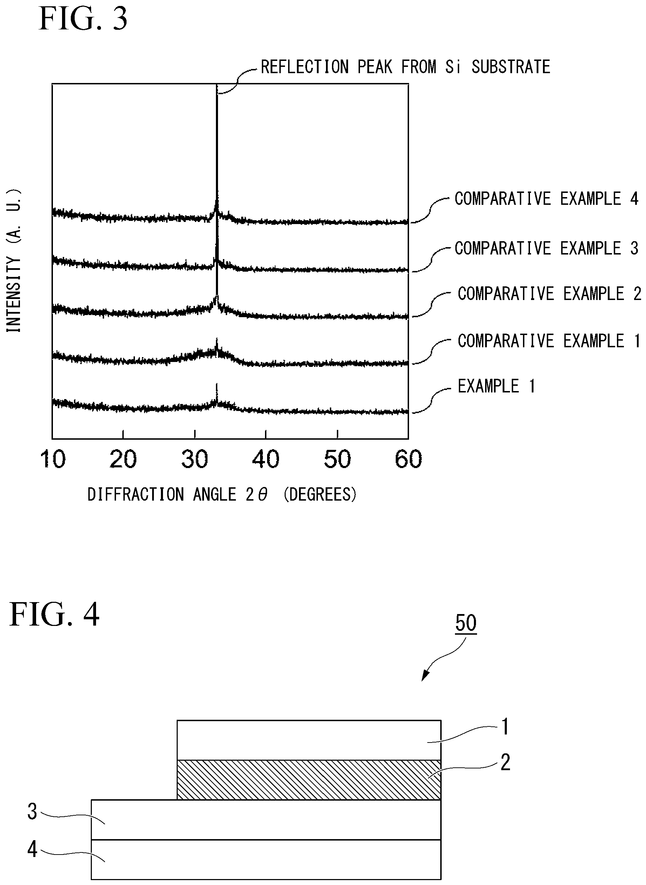

In addition, it was confirmed by an X-ray diffraction method that all of the specimens of Example 1 and Comparative Example 1 to Comparative Example 4 produced on the SiO₂/Si substrates exhibited an amorphous phase. This is shown in FIG. 3. FIG. 3 is a view showing the measurement results of the example and the comparative examples by the X-ray diffraction method. In FIG. 3, the vertical axis represents the intensity in an arbitrary unit, and the horizontal axis represents the diffraction angle 2θ (degrees). In FIG. 3, reflection peaks from the Si substrates are shown. It is found that all patterns do not have any clear peaks except peaks derived from the Si substrates and amorphous phases are exhibited.

### <Measurement of band gap Eg>

Regarding the Hf-Te-O films formed on the sapphire substrates, transmittance spectra were measured, and absorption coefficients were calculated from the obtained results. A Tauc plot was performed based on the obtained absorption coefficients, the band gap Eg of each sample was estimated, and the results shown in Table 1 were obtained. As described above, it is found that, in Comparative Examples 1 to 4, the band gaps Eg are 0.52 or smaller or 1.5 or larger. On the other hand, it was confirmed that the value of the band gap Eg of Example 1 is between 0.52 and 1.5.

### <Evaluation of threshold switch characteristics>

Elements as shown in FIG. 4 were produced to evaluate the threshold switch characteristics of the Hf-Te-O films. FIG. 4 is a cross-sectional view of an element 50 for evaluating the threshold switch characteristics. In order to produce the element 50, first, a 65 nm-thick TiN/W film was formed on a SiO₂/Si substrate 4 as a lower electrode 3, and a 100 nm-thick Hf-Te-O film 2 was formed in a state of coating a part of the lower electrode 3. The purpose of forming this Hf-Te-O film 2 in a state of coating a part of the lower electrode 3 is to expose the part of the lower electrode 3. After that, a resist pattern was formed using photolithography, and a 115 nm-thick W/TiN film was formed as an upper electrode 1. Finally, the resist was removed by lift-off. As the elements, two types of elements were prepared: elements produced by forming the Hf-Te-O film 2 under the same conditions as in Example 1 and elements produced by forming the Hf-Te-O film 2 under the same conditions as in Comparative Example 1.

As the element 50 for evaluating the threshold switch characteristics, elements having the Hf-Te-O film 2 formed under the conditions of Example 1 and elements having the Hf-Te-O film 2 formed under the conditions of Comparative Example 1 were prepared.

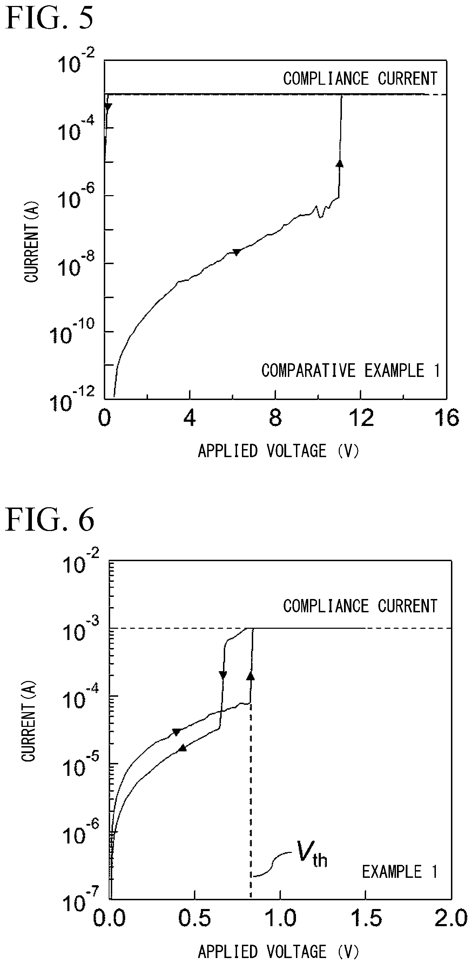

A DC voltage was applied from the upper electrode 1 toward the lower electrode 3 of the element shown in FIG. 4, and a flowing current was measured, thereby evaluating the I (current)-V (voltage) characteristics. FIG. 5 shows the I-V characteristics of Comparative Example 1. A high resistance state was shown in the low-voltage region, and an abrupt current increase was confirmed at approximately 11 V, but the state did not return to high resistance and remained in a low resistance state after the voltage was unloaded. This resistance change is attributed to breakdown and is irreversible. From this fact, it is found that, in the case of a material having a large band gap Eg as in Comparative Example 1, the threshold switch characteristics are not shown and the element does not function as a selector portion. The maximum value of the applied voltage is set to 15 V, and currents in a process of increasing the voltage from 0 V to 15 V and a process of unloading the voltage from 15 V to 0 V are measured. In addition, the compliance current is set to 1 mA to prevent the elements from breaking due to an abrupt increase in current. In addition, the element also did not have threshold switch characteristics in Comparative Example 2, which will not be described in detail.

On the other hand, from the I-V characteristics of Example 1 shown in FIG. 6, the threshold switch characteristics were confirmed. When the voltage was low in the voltage increase process, only several micro amperes to several tens of micro amperes flowed, and a high resistance was shown. At approximately 0.8 V, an abrupt increase in current was shown, the resistance was lowered, and the compliance current value of 1 mA was reached. After that, when approximately 0.6 V was reached in the voltage unload process, an abrupt decrease in current was confirmed, a high resistance state was shown again, and the voltage characteristics were confirmed to be reversible. These results demonstrate that the threshold switch characteristics were shown in Example 1 and indicate that the element can be used as a selector portion.

From these results, there is a demand for the band gap Eg to be in an appropriate range since the threshold switch characteristics cannot be obtained when the band gap Eg is too large. On the other hand, it was confirmed by a simulation, which will be described below, that, when the band gap Eg decreases to the values of Comparative Examples 3 and 4, the electrical resistance of the element becomes too low, and the off state is not shown.

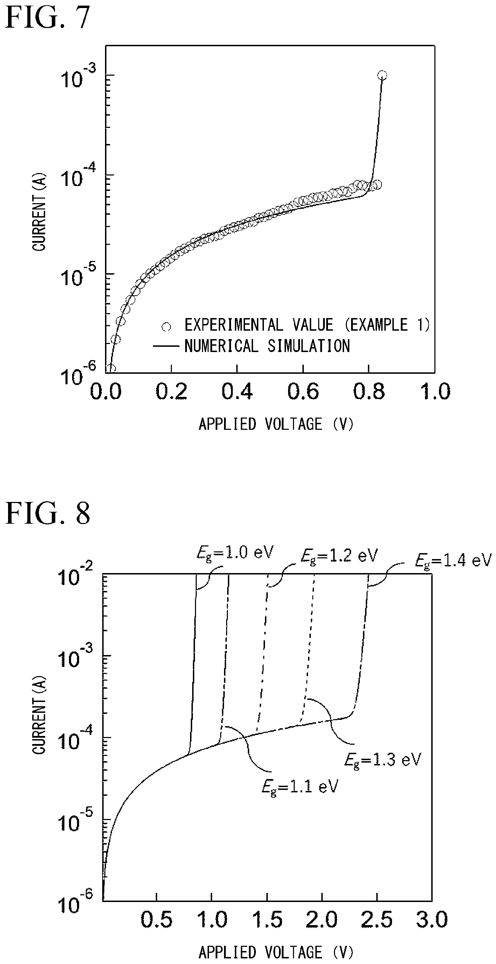

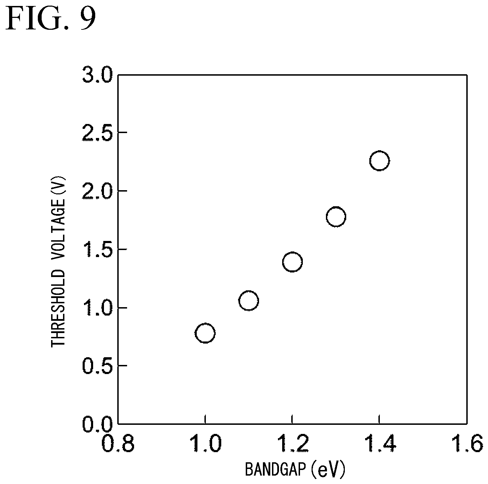

FIG. 7 is a view showing the I-V characteristics of a case where the band gap Eg is 1.0 eV in a numerical simulation and Example 1. As shown in FIG. 7, the I-V characteristics of Example 1 can be almost reproduced in the numerical simulation. Results with the band gap Eg changed in the numerical simulation are shown in FIG. 8 and FIG. 9. FIG. 8 is a view showing the I-V characteristics in the numerical simulation. FIG. 8 shows the I-V characteristics in cases where Eg is 1.0 eV, 1.1 eV, 1.2 eV, 1.3 eV and 1.4 eV In FIG. 8, it is shown that the element has the threshold switch characteristics with respect to all of the above-listed band gaps. On the other hand, FIG. 9 shows the threshold voltage Vₜₕ with respect to the band gap Eg. In FIG. 9, a threshold voltage Vₜₕ at each of the band gaps Eg = 1.0 eV to 1.4 eV is shown. The threshold voltage Vₜₕ is preferably as low as possible, however, when the threshold voltage Vₜₕ becomes lower than 0.8 V that corresponds to a band gap Eg of 1.0 eV, the resistance of the element becomes too small, which is not preferable. Incidentally, in the present numerical simulation, the threshold voltage Vₜₕ that corresponds to a band gap Eg of 1.4 eV is approximately 2.4 V, which is lower than the upper limit (2.7 V) of the threshold voltage Vₜₕ of typical OTS materials. Since the threshold voltage Vₜₕ is preferably as low as possible, when the threshold voltage Vₜₕ is set to 2.0 V or lower, the band gap Eg is in a range of approximately 1.3 eV or smaller in the present numerical simulation. In addition, when the threshold voltage Vₜₕ is set to 1.5 V or lower, the band gap Eg is in a range of approximately 1.2 eV or smaller in the present numerical simulation. In addition, the range of the atomic weight ratio of Hf, Te and O can also be calculated according to the above-described range of the threshold voltage.

### [Reference Signs List]

1, 3 Electrode
2 Hf-Te-O film
4 Substrate
10 Electrode (writing electrode)
20 Electrode (reading electrode)
30 Selector portion
40 Memory portion
50 Threshold switch
100 Cross-point type memory

## Claims

1. An amorphous material that
contains Hf, O and Te as main components and
has characteristics of an electrical resistance transitioning from a first state to a second state that is lower than the first state at a specific threshold voltage.

2. An amorphous material that contains Hf, O and Te as main components and is for a selector in a cross-point type memory.

3. The amorphous material according to Claim 1 or 2,
wherein the amorphous material is represented by a general formula HfₓTe_{y}O_{100-x-y} ··· (1), and
in the formula (1), 23.0 < x < 32.0, 10.0 < y < 22.0 and 35 ≤ x + y ≤ 50.

4. The amorphous material according to Claim 3,
wherein, in the formula (1), 23.0 < x < 30.0 and 13.0 < y < 22.0.

5. The amorphous material according to Claim 3,
wherein, in the formula (1), 23.0 < x < 28.0 and 15.0 < y < 22.0.

6. A cross-point type memory comprising:
a first electrode wiring;
a second electrode wiring;
a memory portion; and
a selector portion containing the amorphous material according to any one of Claims 1 to 5,
wherein the memory portion and the selector portion are disposed between the first electrode wiring and the second electrode wiring.
